(19) Europäisches Patentamt
European Patent Office
Office européen des brevets

(11) **EP 2 141 813 A1**

(12) **EUROPEAN PATENT APPLICATION**

(43) Date of publication:
**06.01.2010 Bulletin 2010/01**

(51) Int Cl.:
***H03L 7/097*** (2006.01)      ***H03L 7/113*** (2006.01)
***H03K 7/08*** (2006.01)

(21) Application number: **08104637.7**

(22) Date of filing: **04.07.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Aksin, Devrim**
**34970 Istanbul (TR)**

(72) Inventors:
• **Aksin, Devrim**
**34970 Istanbul (TR)**

• **Basyurt, Pinar Basak**
**34357 Istanbul (TR)**
• **Uyanik, Hayri Ugur**
**34394 Istanbul (TR)**
• **Ates, Erdogan Ozgur**
**34782 Istanbul (TR)**

(74) Representative: **Sevinç, Erkan**
**Istanbul Patent & Trademark Consultancy Ltd.**
**Plaza-33, Büyükdere cad. No: 33/16**
**Sisli**
**34381 Istanbul (TR)**

(54) **Fully integrated frequency synthesis using PWLL**

(57)    The present invention proposes a frequency synthesizer whose output frequency is digitally controlled by way of locking the same to a voltage ratio rather than the phase of a time reference. The pulse width locked loop consists of a Loop Filter, a voltage controlled oscillator and a frequency to pulse width converter according to the present invention. Proposed FPWC modulates the pulse width of a pulse train with another frequency source and thus converts frequency input to a DC voltage. A high-resolution digital to analog converter is used to generate the loop control voltage. The reference signal of the digital frequency to pulse width converter is obtained using a differential Colpitts oscillator.

Fig. 2

EP 2 141 813 A1

**Description**

**Technical Field of the Invention**

The present invention relates to a fully integrated frequency synthesizer having a digitally controlled output frequency less sensitive to any variability within the system.

**Background of the Invention**

Frequency synthesizer is one of the main building blocks of diverse electronic systems, from analog RF transceivers to digital computer CPUs. They are used whenever a stable and known time reference is needed. Analog PLLs are generally comprised of a phase detector, low pass filter and voltage-controlled oscillator (VCO) in a negative feedback closed-loop configuration. The oscillator outputs a periodic signal. The phase detector changes the control voltage of the oscillator to take it to the same frequency as the reference signal. Phase locked loops function by locking the phase of an in loop voltage controlled oscillator to a precise and accurate time reference.

Phase Locked Loop (PLL) architecture with a Fractional-N frequency divider placed within its feedback path is the most common way of implementing a frequency synthesizer. The oscillation frequency of the time reference together with the division ratio of the Fractional-N divider, determine the output frequency of the synthesizer. There is a wealthy scientific literature about the integration of each and almost every building blocks of the PLLs. Despite the recent and very complex implementation attempts, the lack of precise and accurate integrated oscillators mandated the use of crystal oscillators for reference signal generation.

According to the present invention, a digital frequency to pulse width converter is used to ensure that the output frequency is locked to a voltage ratio rather than the phase of a time reference. The fact that the loop control signal is a voltage ratio allows the generation of the loop control voltage using a high-resolution digital to analog converter to control the output frequency digitally and independent of any variability within the system.

**Objects of the Invention**

Primary object of the present invention is to provide a frequency synthesizer whose output frequency is locked to a voltage ratio rather than the phase of a time reference.

Another object of the present invention is to provide a frequency synthesizer in which the loop control voltage is generated using a high-resolution digital to analog converter so as to control the output frequency digitally and independent of any variability within the system.

Further an object of the present invention is to provide a frequency synthesizer in which reference signal generation requires no use of a crystal oscillator.

**Summary of the Invention**

The present invention proposes a frequency synthesizer whose output frequency is digitally controlled by way of locking the same to a voltage ratio rather than the phase of a time reference. The pulse width locked loop (PWLL) consists of a Loop Filter, a voltage controlled oscillator and a frequency to pulse width converter (FPWC) according to the present invention. Proposed FPWC modulates the pulse width of a pulse train with another frequency source and thus converts frequency input to a DC voltage. A high-resolution digital to analog converter is used to generate the loop control voltage. The reference signal of the digital frequency to pulse width converter is obtained using an LC tank oscillator.

**Brief Description of the Figures**

Accompanying drawings are given solely for the purpose of exemplifying a frequency synthesizer whose advantages over prior art were outlined above and will be explained in detail hereinafter:

Fig. 1 demonstrates the block diagram of the pulse width locked loop (PWLL) according to the present invention.

Fig. 2 demonstrates input and output waveforms of the envisioned frequency to pulse width converter (FPWC) according to the present invention.

Fig. 3 demonstrates functional block diagram of the digital FPWC according to the present invention.

Fig. 4 demonstrates the loop filter of PWLL according to the present invention.

Fig. 5 demonstrates the fully differential ring oscillator structure according to the present invention.

Fig. 6 demonstrates the delay element of the differential ring oscillator according to the present invention.

Fig. 7 demonstrates the frequency control block of the VCO according to the present invention.

Fig. 8 demonstrates the load transistor bias circuit of the delay element according to the present invention.

Fig. 9 demonstrates the fully differential Colpitts Oscillator according to the present invention.

Fig. 10 demonstrates the constant-gm bias circuit according to the present invention.

Fig. 11 demonstrates the $V_{PTAT}$ circuit according to the present invention.

**Detailed Description of the Invention**

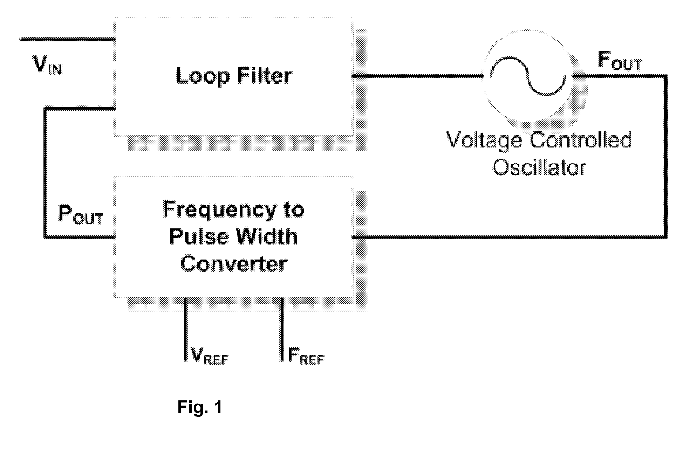

Referring now to the figures outlined above, the basic pulse width locked loop consists of a Loop Filter, a voltage controlled oscillator and a frequency to pulse width converter, as shown in Fig 1. Assuming that loop gain is high, the negative feedback functions in such a way that while the AC component of $P_{OUT}$ is filtered by the loop filter, its DC component is forced to be equal to the input voltage $V_{IN}$ of the loop filter. Fourier analysis of a pulse train indicates that the DC content of a pulse train is equal to the ratio of its pulse width time to the signal period. The core of the Frequency to Pulse Width Converter (FPWC) relies to this observation. The pulse width modulation systems such as Class-D amplifiers or switching regulators modulate the Pulse Width of a pulse train to obtain desired output voltage. To this end, the output signal is filtered to extract the low frequency signal content. The key observation related to this scheme is that the output voltage is not a function of the frequency of the pulse train but solely to the duty cycle of it. This means that the output voltage obtained from a 50% Pulse Width pulse train with amplitude of $V_{REF}$ will always be equal to half of $V_{REF}$ whether its frequency is 100 MHz or 1 KHz. Of course, it will be more difficult to filter out the later. Proposed FPWC modulates the pulse width of a pulse train with another frequency source and thus converts frequency input to a DC voltage. In order to generate its output (Pour), the FPWC block requires a reference frequency input ($F_{REF}$) in addition to the pulse width modulating input frequency ($F_{IN}$).

Since the DC component of the voltage output is generated with pulse width modulation, it is bounded within the voltage range (0, $V_{REF}$). Hence, the valid input signal range of the loop filter is also (0, $V_{REF}$). Due to the facts that the output frequency is the ratio of two voltages, i.e. $V_{REF}$ and $V_{IN}$, and $V_{IN}$ is confined within the range (0, $V_{REF}$), $V_{IN}$ can be generated with a digital to analog converter whose reference voltage is equal to $V_{REF}$. This way any process and temperature variation on the control signal would also be compensated.

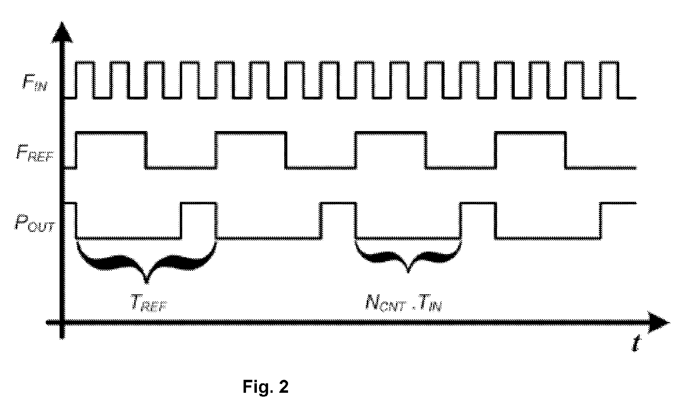

The digital function performed by the FPWC block can be described as follows: The output of the converter goes to logic zero with the rising edge of $F_{REF}$ and return back to logic one after a counter counts $N_{CNT}$ period of $F_{IN}$. Since the pulse width is bounded with the reference signal period, $N_{CNT} \times T_{IN}$ should be less than $T_{REF}$. Realized digital FPWC should also take into the consideration for such case and have necessary control blocks to keep the output at logic zero and reset the counter with the rising edge of $F_{REF}$. For the example shown in Fig 2, $F_{IN}$ is 4 times bigger than $F_{REF}$ and $N_{CNT}$ is equal to 3. Assuming the pulse train is changing between zero and $V_{REF}$, the DC component of the output signal can be expressed as:

$$P_{OUT\_DC} = \left(1 - N_{CNT}\frac{T_{IN}}{T_{REF}}\right)V_{REF}$$

$$= \left(1 - N_{CNT}\frac{F_{REF}}{F_{IN}}\right)V_{REF}$$

Based on the transfer function of the FPWC above, it is possible to derive $F_{OUT}$ by replacing $F_{IN}$ with $F_{OUT}$, equating to $V_{IN}$ and solving for Four.

$$F_{OUT} = \frac{N_{CNT} F_{REF}}{1 - \dfrac{V_{IN}}{V_{REF}}}$$

Within the above expression, $F_{REF}$ is the only process and temperature dependent parameter. If temperature variations are compensated within $F_{REF}$, process dependent variation can be compensated by adjusting $V_{IN}$ with proper DAC code setting. The fact that the control signal of the loop is a ratio of two voltages is very advantageous in that It is possible to obtain the input voltage from said DAC with $V_{REF}$ as its reference voltage therefore making the voltage ratio equal to the digital code given to the DAC and thus making it independent of process, temperature and supply variation. Furthermore, the variable $N_{CNT}$ is also a fixed number independent of any variation. Hence, the variability of $F_{REF}$ is the only concern for the performance of the loop. Although the absolute value of $F_{REF}$ is important in order to obtain desired output frequency, this variability can be compensated easily using the digital control bits of the DAC providing the input signal to the loop. Therefore, $F_{REF}$ frequency's sensitivity to supply and temperature variation is very important and its sensitivity to process variation is not.

Since $F_{IN}$ is an integer multiple of $F_{REF}$ in Fig. 2, their phase relation is not changing from $F_{REF}$ cycle to cycle. If $F_{IN}$ is not an integer multiple of $F_{REF}$, the phase difference at the rising edge of $F_{REF}$ is going to change and as a result the time for the first count of $F_{IN}$ will change from $F_{REF}$ cycle to cycle. The maximum fist count time error is equal to one $F_{IN}$ period.

Initial phase error stems from the fact that initial count time of $F_{IN}$ changes due to the phase shift from $F_{REF}$ cycle to cycle. A simple observation leads to correct this error. The Fourier analysis of a pulse signal will reveal that the DC output voltage is a function of pulse width but not the actual phase of the pulse itself within the period. Therefore, desired DC output signal can also be obtained by triggering the output level changes with $F_{IN}$ and using $F_{REF}$ as an "enable" signal for triggering. Though the initial phase of the pulse changes from $F_{REF}$ cycle to cycle, this scheme guarantees that the pulse width is exactly equal to $N_{CNT} \times T_{IN}$.

The initial phase of the pulse will be calculated next. The ratio of $T_{REF}$ to $T_{IN}$ can be expressed as:

$$\frac{T_{REF}}{T_{IN}} = T_{INT} + T_{FRAC}$$

In the above expression, $T_{INT}$ and $T_{FRAC}$ represent integer and fractional number of period respectively. Initial phase error occurs due to non-zero $T_{FRAC}$. $T_{FRAC}$ gives the amount of phase shift in between $F_{IN}$ and $F_{REF}$ for each $F_{REF}$ cycle and it is bounded within [0, 1). $T_{FRAC}$ being equal to zero means $F_{IN}$ and $F_{REF}$ are in phase and being equal to one means the phase shift is 360 degree for each $F_{REF}$ period. $T_{FRAC}$ can be expressed as follows:

$$T_{FRAC} = \frac{T_{REF}}{T_{IN}} - \left\lfloor \frac{T_{REF}}{T_{IN}} \right\rfloor$$

Assuming both signals are in phase at time equal to zero, the first count time of the next $F_{REF}$ rising edge will be one fractional period smaller than one $F_{IN}$ period. With each consecutive $F_{REF}$ period, the subtracted fractional periods add up till the sums reach/exceed 1 meaning 360 degree phase shift.

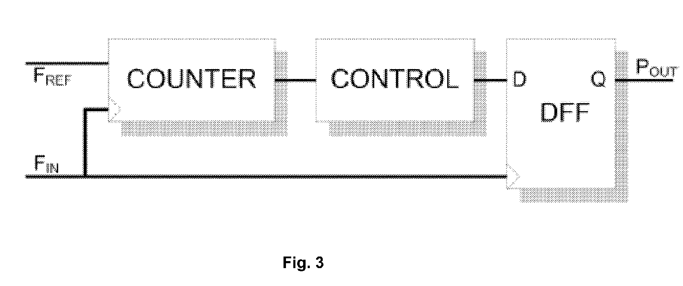

The functional block diagram of the digital FPWC is given in Fig. 3. The critical advantage of this scheme is that there is only one DFF (D flip-flop) in between pulse width modulated output and the frequency input and the output signal is triggered only with $F_{IN}$.

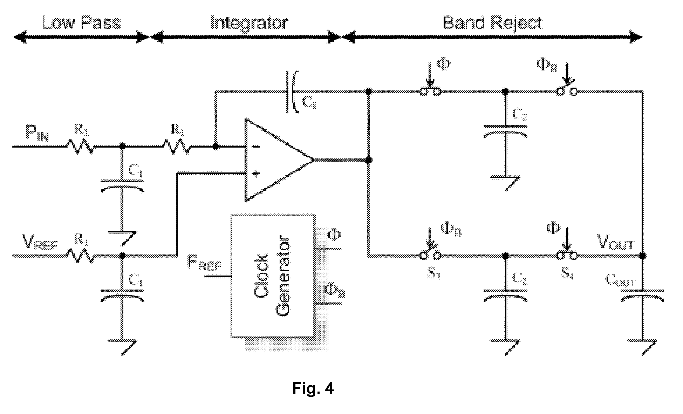

A possible implementation of the loop filter of PWLL as shown in Fig. 4 consists of three stages; a low pass filter followed by an integrator stage and then a SC band reject filter according to the present invention. The inputs to the low pass section, i.e. $P_{IN}$ and $V_{REF}$, are the pulse width modulated input and the reference voltage respectively. Due to the high DC gain of the integrator, presented loop filter cannot operate open loop but when placed in a loop, the negative feedback forces the DC voltage of $P_{IN}$ to be equal to $V_{REF}$. Since the clock signals of the band reject signal is derived from $F_{REF}$ of FPWC, the high frequency content of $P_{IN}$ is removed at the output of the loop filter. It is also possible to interpret the function of the switched capacitor section of the filter as sampling of integrated $P_{IN}$ at the integer multiple of its period hence eliminating its high frequency component.

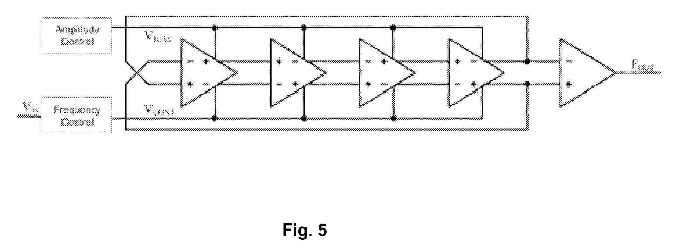

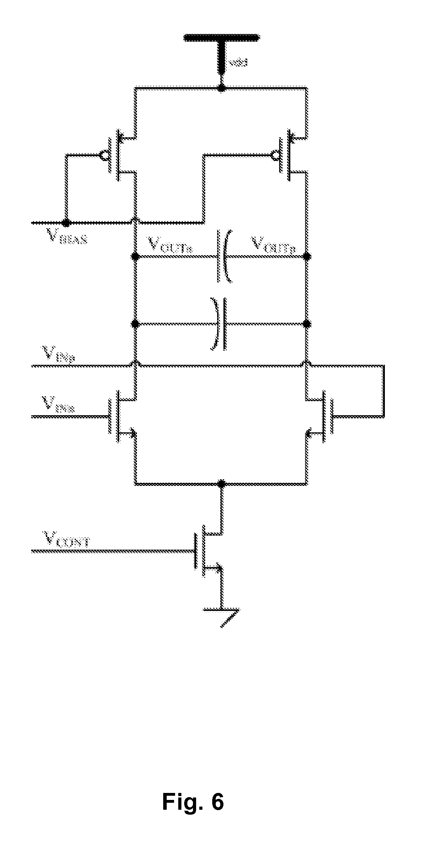

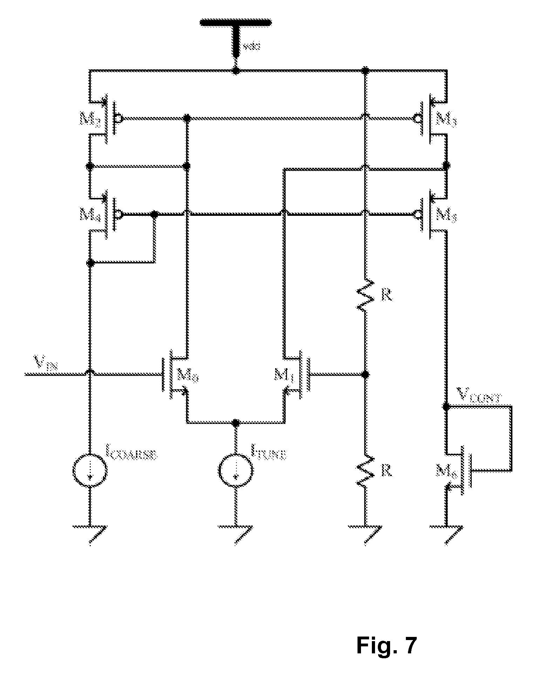

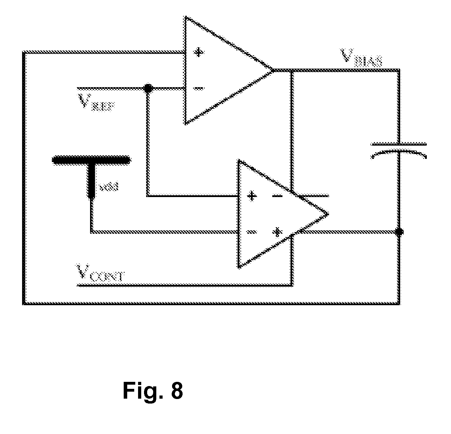

Fully differential ring oscillator structure, shown in Fig. 5, can be used to implement the voltage controlled oscillator of the pulse with locked loop. The unit delay element is implemented with a simple capacitive loaded differential pair as shown in Fig. 6. The tail current of the delay element is generated using a trans-conductance stage converting the loop filter output to the frequency control signal ($V_{CONT}$). Fig. 7 shows the frequency control block. In order to reduce the VCO gain, designed frequency control stage has coarse tuning and fine tuning inputs. Digitally controlled coarse tuning current selects the targeted output frequency range and the loop controls the fine tuning input. Finally, a simple feedback amplifier employing the delay element as its second gain stage is used to generate the bias voltage ($V_{BIAS}$) of the delay element's load transistor, as shown in Fig. 8, in order to fix the oscillation magnitude.

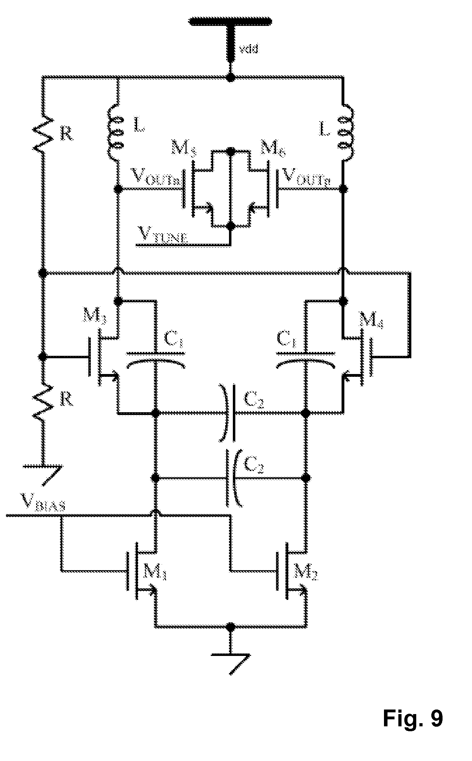

Since the change of $F_{REF}$ absolute value due to the process variation can be compensated easily by adjusting the loop control voltage, its frequency insensitivity to the temperature and supply variation is the main requirement for the reference signal $F_{REF}$. The LC tank oscillator structure is an ideal candidate to implement the desired reference signal generator since the resonance frequency of the tank is determined mainly by the tank inductance and capacitance. Furthermore, it is possible to implement the LC oscillator using bondwire inductances to save space and power since the absolute value of the resonance frequency is not critical. The schematic of the fully differential LC Colpitts oscillator is shown in Fig. 9.

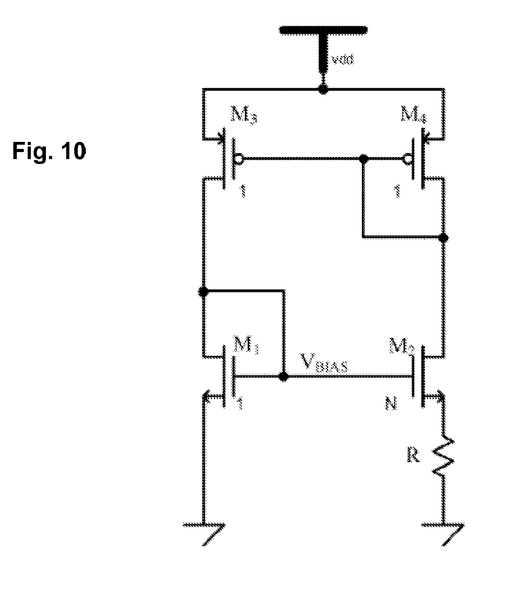

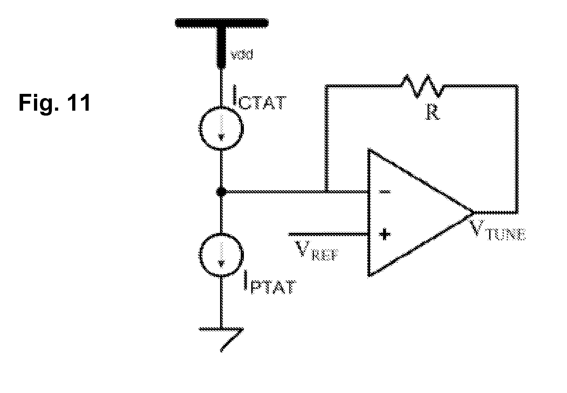

The trans-conductance of the MOS transistors degrades with increasing temperature. The tank elements, i.e. inductance and capacitances, are also affected with the temperature. For on chip spiral inductances, its serial resistance increases with temperature while its inductance remains unchanged. The inductance of the bondwire on the other hand increases with temperature due to the dilatation of the bondwire. The tank capacitance value also increases with temperature. In order to improve the temperature stability of the Differential LC Colpitts Oscillator; a simple constant-gm biasing scheme is used to fix the MOS trans-conductance at first order and a MOS varractor together with a programmable controlling voltage proportional to absolute temperature ($V_{PTAT}$) is used to compensate the resonance frequency shift. The constant-gm bias circuit is shown in Fig. 10. The $V_{PTAT}$ circuit is shown in Fig. 11.

**Claims**

1. A frequency synthesizer comprising a loop filter, a voltage controlled oscillator (VCO) and a digital frequency to pulse width converter (FPWC) placed between the output and the feedback input of a pulse width locked loop (PWLL) wherein input voltage ($V_{IN}$) is obtained from a digital to analog converter (DAC) having a reference voltage ($V_{REF}$) in common with said frequency to pulse width converter (FPWC) and said frequency to pulse width converter (FPWC) modulating the pulse width of a pulse train ($F_{REF}$) with another frequency source ($F_{IN}$) and a counter ($N_{CNT}$) to convert frequency input to a DC voltage.

2. A frequency synthesizer as in Claim 1 wherein said frequency to pulse width converter (FPWC) is designed to output logic zero after the rising edge of $F_{REF}$ and to return back to logic one after said counter counts $N_{CNT}$ period of $F_{IN}$.

3. A frequency synthesizer as in Claim 2 wherein said frequency to pulse width converter (FPWC) comprises a control block for keeping the output at logic zero and reset said counter ($N_{CNT}$) with the rising edge of $F_{REF}$ if $N_{CNT} \times T_{IN}$ is larger than $T_{REF}$.

4. A frequency synthesizer as in Claim 2 or 3 wherein said frequency to pulse width converter (FPWC) comprises one D flip-flop in between pulse width modulated output and the frequency input.

5. A frequency synthesizer as in Claim 4 wherein the output signal of said frequency to pulse width converter (FPWC) is triggered only with $F_{IN}$.

6. A frequency synthesizer as in Claim 1 or 5 wherein reference frequency ($F_{REF}$) of said frequency to pulse width converter (FPWC) is obtained using a LC tank oscillator.

7. A frequency synthesizer as in any preceding claims wherein a 16Bits $3^{rd}$ order delta sigma digital to analog converter is used to generate the loop control voltage and to control the output frequency.

8. A frequency synthesizer as in Claim 1 wherein said loop filter of PWLL comprises a low pass filter followed by an integrator stage and then a SC band reject filter.

9. A frequency synthesizer as in Claim 8 wherein clock signals of said band reject signal is derived from $F_{REF}$ of frequency to pulse width converter (FPWC) whereby the high frequency content of $P_{IN}$ is removed at the output of said loop filter.

10. A frequency synthesizer as in Claim 1 wherein a fully differential ring oscillator is used to implement said voltage controlled oscillator (VCO) of the pulse with locked loop (PWLL).

11. A frequency synthesizer as in Claim 10 wherein unit delay element of the differential ring oscillator is implemented with a capacitive loaded differential pair.

12. A frequency synthesizer as in Claim 11 wherein tail current of said delay element is generated using a transconductance stage converting the loop filter output to frequency control signal ($V_{CONT}$).

13. A frequency synthesizer as in Claim 6 wherein said LC oscillator is implemented using bondwire inductances.

14. A frequency synthesizer as in Claim 6 wherein a constant-$g_m$ biasing scheme is used to fix the MOS transconductances at first order and a MOS varactor together with a programmable controlling voltage proportional to absolute temperature ($V_{PTAT}$) is used to compensate the resonance frequency shift whereby temperature stability of the differential LC Colpitts oscillator is improved.

15. A method for providing feedback input of a pulse width locked loop (PWLL) of a frequency synthesizer comprising a loop filter, a voltage controlled oscillator (VCO) and a digital frequency to pulse width converter (FPWC), said method comprising the steps of modulating the pulse width of a pulse train ($F_{REF}$) from an LC tank oscillator with another frequency source ($F_{IN}$) and a counter ($N_{ONT}$), by outputting logic zero after the rising edge of $F_{REF}$ and logic one after a counter counts $N_{CNT}$ period $F_{IN}$, resetting said counter ($N_{CNT}$) with the rising edge of $F_{REF}$.

**Fig. 1**

**Fig. 2**

$F_{REF}$

COUNTER — CONTROL — D    Q — $P_{OUT}$

DFF

$F_{IN}$

Fig. 3

Fig. 4

**Fig. 5**

**Fig. 6**

**Fig. 7**

**Fig. 8**

Fig. 9

**Fig. 10**

**Fig. 11**

Europäisches
Patentamt

European
Patent Office

Office européen
des brevets

## EUROPEAN SEARCH REPORT

Application Number

EP 08 10 4637

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 207 539 A (MINAKUCHI HIROSHI [JP]) 10 June 1980 (1980-06-10) * column 2, line 62 - column 3, line 43 * * column 5, lines 15-54; figures 1,3,4 * ----- | 1-4,6, 10-13,15 | INV. H03L7/097 H03L7/113 ADD. H03K7/08 |
| A | US 2001/038317 A1 (KASPERKOVITZ WOLFDIETRICH GEOR [NL]) 8 November 2001 (2001-11-08) * the whole document * ----- | 1-15 | |
| A | US 6 262 609 B1 (HAFEZ AMR N [CA] ET AL) 17 July 2001 (2001-07-17) * column 2, line 56 - column 4, line 10; figures 1,2 * ----- | 1-15 | |
| A | SU 647 864 A1 (KATRENKO YURIJ N [SU]; KORNIENKO ALEKSANDR YA; NEJSHTADT MOISEJ) 15 February 1979 (1979-02-15) * the whole document * -& DATABASE WPI Thomson Scientific, London, GB; AN 1979-K5849B XP002504714 "Frequency-to-pulse width signal transducer for computing - has clock frequency input to AND=gate at input to OR=gate for auxiliary counter" * abstract * ----- | 1-15 | TECHNICAL FIELDS SEARCHED (IPC) H03L |

The present search report has been drawn up for all claims

| Place of search | Date of completion of the search | Examiner |
|---|---|---|
| Munich | 20 November 2008 | Waters, Duncan |

EPO FORM 1503 03.82 (P04C01)

**ANNEX TO THE EUROPEAN SEARCH REPORT
ON EUROPEAN PATENT APPLICATION NO.**

EP 08 10 4637

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2008

| Patent document cited in search report | | Publication date | Patent family member(s) | | Publication date |
|---|---|---|---|---|---|
| US 4207539 | A | 10-06-1980 | JP<br>JP<br>JP<br>US | 1241229 C<br>53084449 A<br>59015220 B<br>4301422 A | 26-11-1984<br>25-07-1978<br>07-04-1984<br>17-11-1981 |
| US 2001038317 | A1 | 08-11-2001 | CN<br>WO<br>JP | 1366734 A<br>0180427 A1<br>2003531549 T | 28-08-2002<br>25-10-2001<br>21-10-2003 |
| US 6262609 | B1 | 17-07-2001 | NONE | | |
| SU 647864 | A1 | 15-02-1979 | NONE | | |

EPO FORM P0459

For more details about this annex : see Official Journal of the European Patent Office, No. 12/82